# DEMANDE DE BREVET EUROPEEN

(11) **EP 2 325 873 A1**
(43) Date de publication de la demande: **25.05.2011**
(21) Numéro de dépôt: 10191762.3
(22) Date de dépôt: 18.11.2010
(51) Int. Cl.: H01L 21/336, H01L 29/786

(54) **Procédé de fabrication d'une membrane suspendue et transistor MOS à double grille**

(30) Priorité: 23.11.2009 FR 0958280
(71) Demandeur: STMicroelectronics (Crolles 2) SAS, 38920 Crolles (FR)
(72) Inventeur: Monfray, Stéphane, 38320, EYBENS (FR); Skotnicki, Thomas, 38920, CROLLES-MONTFORT (FR)
(74) Mandataire: de Beaumont, Michel

(57) **Abrégé**

L'invention concerne un procédé de fabrication d'une membrane suspendue (44) dans un substrat semi-conducteur monocristallin, comprenant les étapes suivantes : former dans le substrat une couronne d'isolement (2) délimitant une zone active, creuser la zone active, former successivement dans la zone active une première et une deuxième (44) couches, la deuxième couche étant une couche semi-conductrice monocristalline, graver une partie de la périphérie interne de ladite couronne sur une profondeur supérieure à l'épaisseur de la deuxième couche, éliminer la première couche de sorte que la deuxième couche constitue une membrane suspendue ancrée dans la couronne d'isolement.

## Description

### Domaine de l'invention

La présente invention concerne le domaine des circuits intégrés. Elle concerne plus particulièrement les procédés de fabrication de composants électroniques désignés dans la technique par le sigle SON (de l'anglais Silicon On Nothing ou "silicium sur rien").

### Exposé de l'art antérieur

On réalise couramment des transistors MOS sur un substrat de type SOI (de l'anglais Silicon On Insulator ou "silicium sur isolant"). Le coût de ce substrat n'étant pas négligeable, on a proposé de former dans un substrat massif de manière localisée une couche enterrée d'oxyde de silicium sous un film de silicium monocristallin sur lequel sera réalisé le transistor.

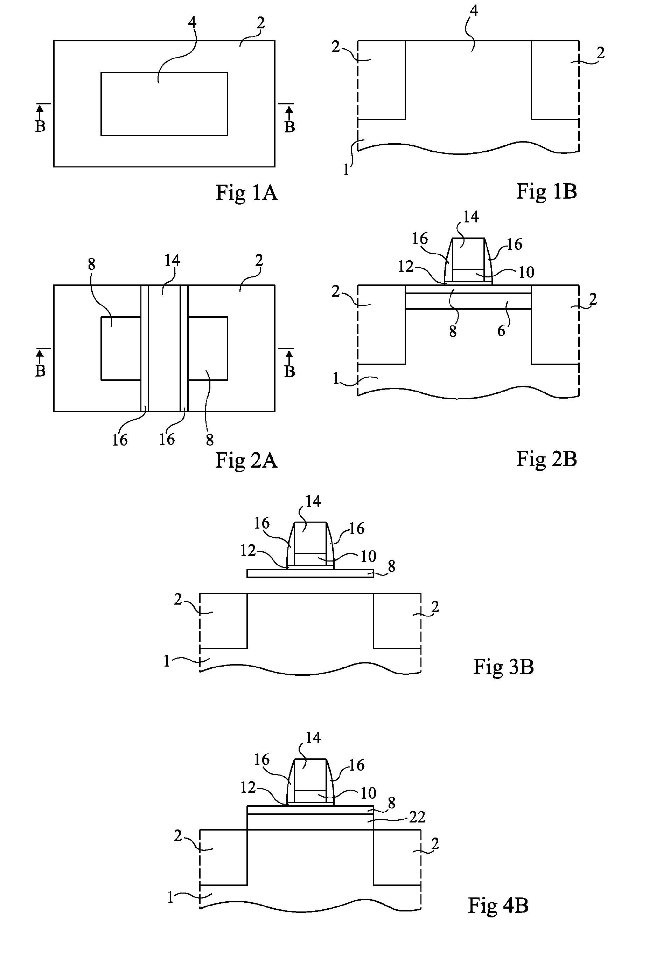

Les figures 1A à 4B illustrent des étapes successives de réalisation d'un transistor MOS sur une portion d'un substrat comprenant une couche d'oxyde de silicium enterrée.

Les figures 1A et 1B sont respectivement une vue de dessus et une vue en coupe selon le plan BB de la figure 1A d'une étape de fabrication initiale. Dans un substrat massif 1 en silicium, on a réalisé une couronne d'isolement 2 délimitant une zone active 4.

A l'étape illustrée par les figures 2A et 2B qui sont respectivement une vue de dessus et une vue en coupe selon le plan BB de la figure 2A, on a gravé la zone active 4 sur une certaine profondeur avant de réaliser successivement par épitaxie une couche sacrificielle 6 en silicium-germanium et une couche 8 en silicium sur une épaisseur correspondant à la profondeur de gravure. On a déposé un isolant de grille 12 sur la couche 8 puis formé une grille métallique 10. La partie supérieure de la grille comprend une couche de silicium polycristallin 14. Deux espaceurs 16 sont réalisés de part et d'autre de la grille 10-14. Comme l'illustre la figure 2A, la grille 10-14 se prolonge sur la couronne d'isolement 2, de part et d'autre de la zone active 4.

A l'étape illustrée à la figure 3B, qui est une vue en coupe d'une étape de fabrication suivante, on a gravé la couronne d'isolement 2 de manière à pouvoir accéder à la couche sacrificielle 6. Ensuite, on a éliminé la couche 6. La tenue mécanique de la membrane suspendue correspondant à la couche 8 est assurée par les prolongements de la grille 10-14 qui s'appuient sur la couronne d'isolement 2.

A l'étape illustrée à la figure 4B qui est une vue en coupe d'une étape de fabrication suivante, on a déposé une couche 22 en oxyde de silicium sous la couche 8. On peut alors former dans la couche de silicium 8 un transistor MOS qui est isolé du substrat 1 par la couche 22. Un tel transistor présente les mêmes avantages qu'un transistor formé dans la couche de silicium supérieure d'une structure de type SOI.

Dans cet exemple, la gravure sélective de la couche sacrificielle 6 par rapport à la couche 8 est réalisée après formation de la grille 10-14. Un gaz de chlorure d'hydrogène à haute température utilisé pour cette étape attaque inévitablement la grille métallique 10, ce qui peut poser problème. En outre, la sélectivité de gravure n'est pas parfaite par rapport aux espaceurs 16 et à l'isolant de grille 12.

### Résumé

Un objet d'un mode de réalisation de la présente invention est de prévoir un procédé de fabrication d'un transistor MOS sur isolant évitant au moins certains des inconvénients des procédés antérieurs.

Un objet plus général d'un mode de réalisation de la présente invention est de prévoir un procédé de fabrication d'une membrane suspendue simple à mettre en oeuvre.

Un objet plus particulier d'un mode de réalisation de la présente invention est de prévoir un procédé de fabrication d'un transistor MOS à double grille.

Ainsi, un mode de réalisation de la présente invention prévoit un procédé de fabrication d'une membrane suspendue dans un substrat semi-conducteur monocristallin, comprenant les étapes suivantes :
former dans le substrat une couronne d'isolement délimitant une zone active,
creuser la zone active,
former successivement dans la zone active une première et une deuxième couches, la deuxième couche étant une couche semi-conductrice monocristalline,
graver une partie de la périphérie interne de ladite couronne sur une profondeur supérieure à l'épaisseur de la deuxième couche,
éliminer la première couche de sorte que la deuxième couche constitue une membrane suspendue ancrée dans la couronne d'isolement.

Selon un autre mode de réalisation de la présente invention, la profondeur de gravure correspond sensiblement à la profondeur de creusement de la zone active.

Selon un autre mode de réalisation de la présente invention, l'épaisseur de la première couche est comprise entre 10 et 50 nm, de préférence entre 15 et 25 nm et l'épaisseur de la deuxième couche est comprise entre 2 et 20 nm, de préférence entre 5 et 10 nm, la profondeur de gravure étant comprise entre 4 et 100 nm, de préférence entre 10 et 40 nm.

Un autre mode de réalisation de la présente invention prévoit un procédé de formation d'un transistor MOS à double grille comprenant les étapes suivantes :
mettre en oeuvre le procédé décrit ci-dessus,
déposer une couche de résine sur et sous la membrane,
insoler la couche de résine par faisceau d'électrons ou par radiations extrêmes ultraviolettes et développer la couche de résine de manière à former dans la couche de résine une tranchée supérieure sur la membrane et une tranchée inférieure sous la membrane, les deux tranchées étant alignées et la tranchée inférieure débouchant sur la périphérie interne gravée de la couronne d'isolement,
déposer un conducteur de grille isolée dans les tranchées sur et sous la membrane,
éliminer la couche de résine insolée.

Selon un autre mode de réalisation de la présente invention, la couche de résine se transforme en oxyde de silicium après l'étape d'insolation et après une étape de recuit.

Selon un autre mode de réalisation de la présente invention, une couche d'isolement de grille est formée sur et sous la membrane avant le dépôt de la couche de résine.

Selon un autre mode de réalisation de la présente invention, une couche d'isolement de grille est formée dans les tranchées sur et sous la membrane.

Selon un autre mode de réalisation de la présente invention, la couche d'isolement de grille est de l'oxyde d'hafnium.

Un autre mode de réalisation de la présente invention prévoit un dispositif comprenant une zone active formée dans un substrat semi-conducteur monocristallin délimitée par une couronne d'isolement, la couronne comprenant au moins deux épaisseurs distinctes, la différence des deux épaisseurs correspondant à une profondeur de gravure d'une partie de la périphérie interne de ladite couronne, la zone active comprenant une membrane suspendue dont des flancs sont solidaires de la région d'isolement.

Selon un autre mode de réalisation de la présente invention, le dispositif comprend des conducteurs de grilles isolées supérieure et inférieure, disposés respectivement sur et sous la membrane, la membrane comprenant des régions de source et de drain.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
les figures 1A et 2A, précédemment décrites, sont des vues schématiques de dessus illustrant les étapes initiales d'un procédé de fabrication d'un transistor MOS ;
les figures 1B et 2B, précédemment décrites, sont des vues schématiques en coupe selon le plan BB des figures 1A et 2A ;
les figures 3B et 4B, précédemment décrites, sont des vues schématiques en coupe illustrant des étapes du procédé de fabrication du transistor MOS ;
les figures 5A et 6A sont des vues schématiques de dessus illustrant les étapes initiales d'un procédé de fabrication d'une membrane suspendue, selon un mode de réalisation de la présente invention ;
les figures 5B et 6B sont des vues schématiques en coupe selon le plan BB respectivement des figures 5A et 6A ;
les figures 6C, 6D et 6E sont des vues schématiques en coupe respectivement selon les plans CC, DD et EE de la figure 6A ;
la figure 7B est une vue schématique en coupe illustrant des étapes d'un procédé de fabrication d'une membrane ;
les figures 7D et 7E sont des vues schématiques en coupe respectivement selon les plans DD et EE de la figure 7B ;
les figures 8A et 9A sont des vues schématiques de dessus illustrant un procédé de fabrication d'un transistor MOS à double grille ; et
les figures 8B et 9B sont des vues schématiques en coupe selon le plan BB respectivement des figures 8A et 9A.

### Description détaillée

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

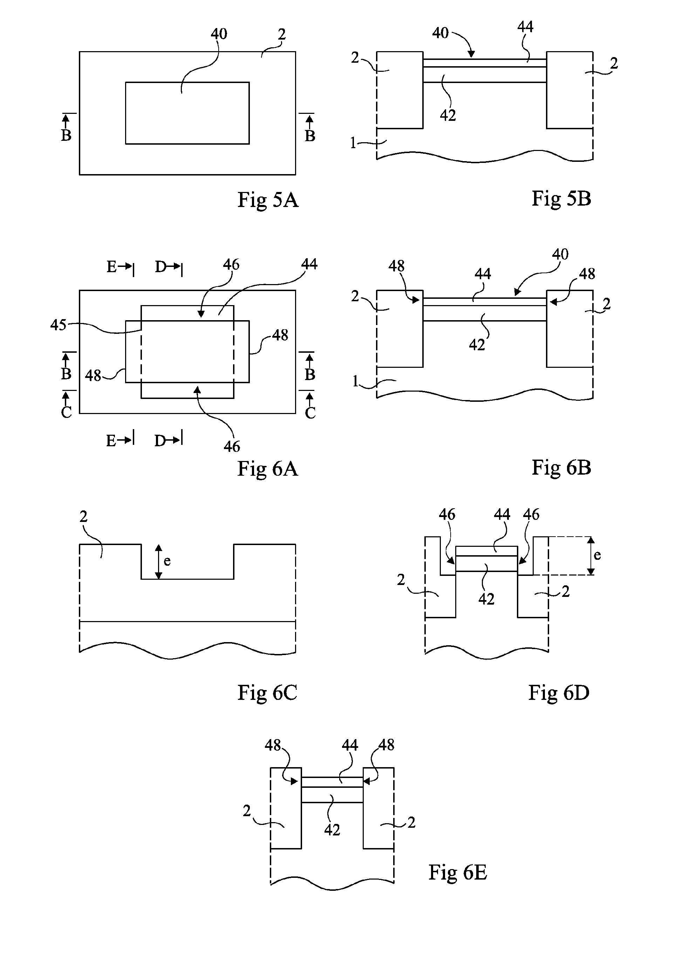

En figures 5A et 5B, on a représenté un substrat massif 1 en matériau semiconducteur monocristallin, par exemple en silicium, dans lequel on a formé une couronne d'isolement 2 délimitant une zone active 40. La couronne d'isolement 2 est par exemple en oxyde de silicium. On a ensuite creusé la zone 40 en gravant en partie le silicium, par exemple par un gaz de chlorure d'hydrogène à haute température sur une profondeur inférieure à celle de la couronne d'isolement. On a formé par épitaxie une couche sacrificielle 42, par exemple en silicium-germanium, puis une couche semi-conductrice monocristalline 44, par exemple en silicium. La surface supérieure de la couche 44 est au niveau de la surface supérieure de la couronne d'isolement 2 ou légèrement en dessous. L'épaisseur de la couche sacrificielle 42 est par exemple comprise entre 10 et 50 nm, de préférence entre 15 et 25 nm. L'épaisseur de la couche 44 est par exemple comprise entre 2 et 20 nm, de préférence entre 5 et 10 nm.

En figures 6A à 6E, on a représenté le résultat d'une étape au cours de laquelle on a gravé sélectivement une partie de la périphérie interne de la couronne d'isolement 2. Cette gravure sélective est effectuée dans l'ouverture d'un masque 45. Dans une première direction, horizontale dans la figure 6A, cette ouverture 45 est moins large que la zone active 40. Dans une seconde direction, verticale dans la figure 6A, l'ouverture 45 est plus large que la zone active 40. On a ainsi gravé des parties opposées verticalement de la périphérie de la zone active pour former des accès 46. Ainsi, des flancs 48, opposés dans la direction horizontale, de la couche 44 sont en contact avec la couronne d'isolement 2 et sont solidaires de celle-ci, comme on le voit en figures 6A, 6B et 6E.

Comme l'illustre la figure 6D, la profondeur e de gravure est supérieure à l'épaisseur de la couche 44. De cette manière, on forme les accès latéraux 46 à la couche sacrificielle 42. En figures 6A à 6E, la profondeur e de gravure correspond sensiblement à la profondeur de creusement de la zone active 40. Ainsi, les accès 46 à la couche 42 sont dégagés sur toute l'épaisseur de cette couche. La profondeur e de la gravure est comprise entre 4 et 100 nm, de préférence entre 10 et 40 nm.

A titre d'exemple, la gravure de la couronne d'isolement 2 peut se faire par voie humide en utilisant par exemple une solution d'acide fluorhydrique ou par plasma en utilisant par exemple un plasma de C₄H₈.

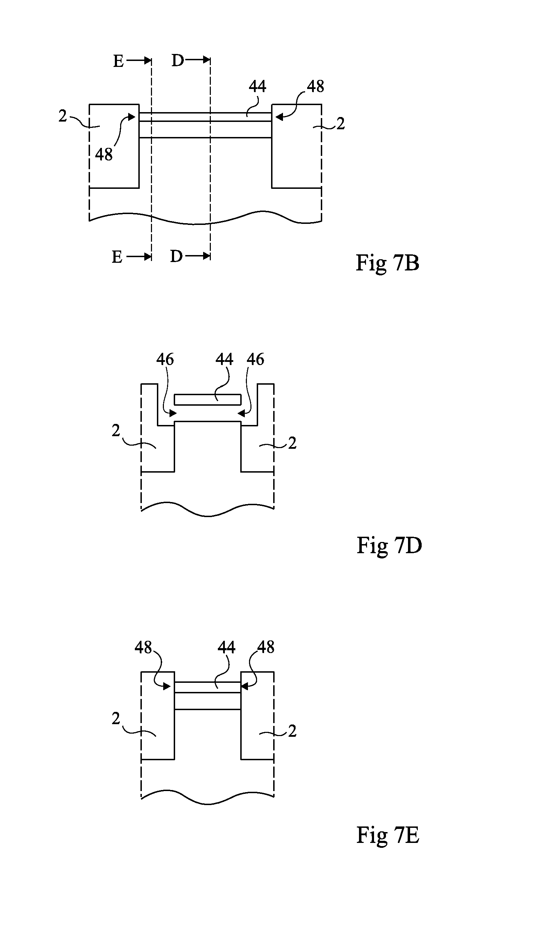

Les figures 7B, 7D et 7E sont des vues en coupe, illustrant une étape du procédé de fabrication d'une membrane suspendue, qui correspondent respectivement aux coupes des figures 6B, 6D et 6E. Dans ces figures, on a représenté le résultat d'une étape au cours de laquelle on a éliminé la couche sacrificielle 42. La couche 44 constitue ainsi une membrane suspendue. La gravure de la couche 44 a été effectuée de manière latérale par les accès 46, comme on le voit en figure 7D. A titre d'exemple, on a pu réaliser une gravure sèche en utilisant par exemple un gaz de chlorure d'hydrogène à haute température ou une gravure par plasma en utilisant par exemple un plasma CF₄. La membrane suspendue est solidaire de la couronne d'isolement 2 par les flancs 48 opposés. La tenue mécanique de la membrane 44 est assurée par ancrage des flancs 48 dans la partie de la couronne d'isolement 2 non gravée.

Selon un aspect d'un mode de réalisation de la présente invention, on dépose une couche isolante, sous la membrane 44. La couche isolante peut être par exemple de l'oxyde de silicium. A titre d'exemple, on peut prévoir de déposer cette couche par un procédé de dépôt chimique en phase vapeur couramment désigné par le sigle CVD (de l'anglais Chemical Vapor Déposition).

On peut alors prévoir de réaliser une grille sur une couche isolante déposée sur la membrane 44. On réalise ensuite les régions de source et drain de part et d'autre de la région de canal formée dans la membrane 44. On obtient ainsi un transistor MOS sur une portion du substrat localement de type silicium sur isolant. La grille étant réalisée après élimination de la couche sacrificielle 42, les différents éléments du transistor ne sont pas affectés par la gravure de cette couche sacrificielle.

Le procédé décrit en relation avec les figures 5A à 7E peut également être appliqué à la réalisation d'un transistor MOS à double grille.

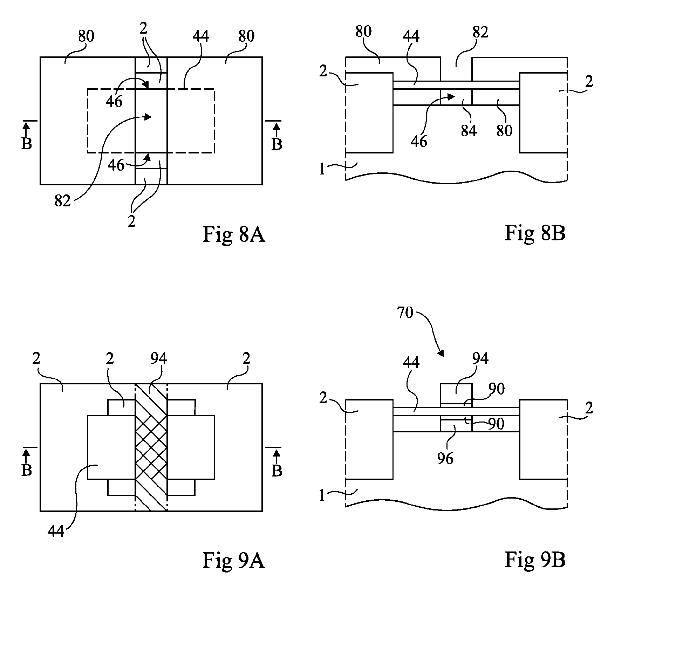

Les figures 8A à 9B illustrent des étapes de réalisation d'un procédé de formation d'un transistor MOS 70 à double grille.

En figures 8A et 8B, on a représenté en vue de dessus et en vue en coupe le dispositif des figures 7B-7E dans lequel, après formation de la membrane suspendue 44, on a procédé au dépôt d'une résine 80 sur et sous la membrane 44. Avantageusement, la résine 80 est une résine du type résine HSQ (Hydrogen SilsesQuioxane) ou du type résine PMMA (polyméthacrylate de méthyle). Après insolation par un faisceau d'électrons, développement et recuit d'une telle résine, elle se transforme en oxyde de silicium.

On a formé dans la résine 80 une tranchée supérieure 82 sur la membrane et une tranchée inférieure 84 sous la membrane comme on le voit en figure 8B. Les deux tranchées sont alignées. Les tranchées débouchent sur la périphérie interne gravée de la couronne 2. Ainsi, deux portions d'accès 46 non remplies de résine 80 permettent d'accéder à la tranchée 84. Comme l'illustre la figure 8A, les deux portions d'accès 46 sont formées verticalement de manière opposée par rapport à la membrane 44. Les tranchées 82 et 84 ont été réalisées par une étape de lithographie par faisceau d'électrons ou par des radiations extrêmes ultraviolettes. L'épaisseur de la membrane 44, avantageusement comprise entre 2 et 20 nm, de préférence entre 5 et 10 nm, est suffisamment fine pour permettre l'insolation par le faisceau d'électrons ou par les radiations extrêmes ultraviolettes de la résine 80 disposée sous la membrane. On a procédé ensuite au développement de la résine 80 puis à une étape de recuit de la résine.

En figures 9A et 9B, on a déposé ou fait croître un isolant de grille 90 sur et sous la membrane 44 par les portions d'accès 46 dans chacune des tranchées 82 et 84. A titre d'exemple, l'isolant de grille peut être de l'oxyde de silicium ou de l'oxyde d'hafnium. Comme on le voit en figure 9B, on a ensuite procédé au dépôt d'un matériau conducteur qui forme une grille isolée supérieure 94 au-dessus de la membrane et une grille isolée inférieure 96 sous la membrane. Comme l'illustre la figure 9A, la grille supérieure 94 symbolisée par des hachures simples s'étend sur la couronne d'isolement 2 de part et d'autre de la membrane 44, alors que la grille inférieure 96, symbolisée par des hachures doubles, ne s'étend que sous la membrane 44.

A titre d'exemple, les grilles conductrices 94 et 96 sont en nitrure de titane. Le conducteur n'étant utile qu'à l'interface avec l'oxyde de grille, une faible épaisseur de conducteur est suffisante. On a alors complété la grille, et donc les tranchées, par une couche en silicium polycristallin. Pour ce faire, on a utilisé un procédé dit damascène en déposant du silicium polycristallin sur la couche 80 de manière à remplir les tranchées 82 et 84. On a poli chimiquement et mécaniquement la couche de silicium polycristallin dépassant de la tranchée 82 jusqu'à la couche 80 d'oxyde de silicium constituant une couche d'arrêt. La couche 80 a alors été éliminée par exemple par une solution d'acide fluorhydrique. La couche d'isolement de grille 90 est avantageusement de l'oxyde d'hafnium. Ainsi, la gravure de la couche 80 d'oxyde de silicium est sélective par rapport à la couche d'isolement de grille 90.

On a procédé à la formation des régions de source et de drain dans la membrane 44, de part et d'autre de la région de canal interposée entre les deux grilles isolées 94 et 96.

Ce procédé permet d'obtenir un transistor MOS 70 à double grille dont les deux grilles sont auto-alignées.

En variante, on peut prévoir de former une couche d'isolement de grille sur et sous la membrane 44 avant le dépôt de la couche de résine 80. Ainsi, cette couche fera office de couche d'arrêt à la gravure de la couche 80 une fois insolée, développée et recuite.

Des modes de réalisation particuliers de la présente invention ont été décrits. Diverses variantes et modifications apparaîtront à l'homme de l'art. En particulier, les grilles du transistor à double grille 70 peuvent être réalisées intégralement en silicium polycristallin. En outre, les deux grilles isolées supérieure 94 et inférieure 96 peuvent être reliées entre elles suite à un dépôt de matériau de grille enrobant la membrane 44.

Divers modes de réalisation avec diverses variantes ont été décrits ci-dessus. On notera que l'homme de l'art pourra combiner divers éléments de ces divers modes de réalisation et variantes sans faire preuve d'activité inventive.

## Revendications

1. Procédé de fabrication d'une membrane suspendue (44) dans un substrat semi-conducteur (1) monocristallin, comprenant les étapes suivantes :
former dans le substrat une couronne d'isolement (2) délimitant une zone active (40),
creuser la zone active,
former successivement dans la zone active une première (42) et une deuxième (44) couches, la deuxième couche étant une couche semi-conductrice monocristalline,
graver une partie de la périphérie interne de ladite couronne sur une profondeur (e) supérieure à l'épaisseur de la deuxième couche,
éliminer la première couche de sorte que la deuxième couche constitue une membrane suspendue ancrée dans la couronne d'isolement.

2. Procédé selon la revendication 1, dans lequel la profondeur de gravure correspond sensiblement à la profondeur de creusement de la zone active.

3. Procédé selon la revendication 1 ou 2, dans lequel l'épaisseur de la première couche est comprise entre 10 et 50 nm, de préférence entre 15 et 25 nm et l'épaisseur de la deuxième couche est comprise entre 2 et 20 nm, de préférence entre 5 et 10 nm, la profondeur de gravure étant comprise entre 4 et 100 nm, de préférence entre 10 et 40 nm.

4. Procédé de formation d'un transistor MOS (70) à double grille comprenant les étapes suivantes :
mettre en oeuvre le procédé selon l'une quelconque des revendications 1 à 3,
déposer une couche de résine (80) sur et sous la membrane,
insoler la couche de résine par faisceau d'électrons ou par radiations extrêmes ultraviolettes et développer la couche de résine de manière à former dans la couche de résine une tranchée supérieure (82) sur la membrane et une tranchée inférieure (84) sous la membrane, les deux tranchées étant alignées et la tranchée inférieure débouchant sur la périphérie interne gravée de la couronne d'isolement,
déposer un conducteur de grille isolée (94, 96) dans les tranchées sur et sous la membrane,
éliminer la couche de résine insolée.

5. Procédé selon la revendication 4, dans lequel la couche de résine se transforme en oxyde de silicium après l'étape d'insolation et après une étape de recuit.

6. Procédé selon la revendication 4 ou 5, dans lequel une couche d'isolement de grille (90) est formée sur et sous la membrane avant le dépôt de la couche de résine.

7. Procédé selon la revendication 4 ou 5, dans lequel une couche d'isolement de grille (90) est formée dans les tranchées sur et sous la membrane.

8. Procédé selon la revendication 7, dans lequel la couche d'isolement de grille est de l'oxyde d'hafnium.

9. Dispositif comprenant une zone active (40) formée dans un substrat semi-conducteur (1) monocristallin délimitée par une couronne d'isolement (2), la couronne comprenant au moins deux épaisseurs distinctes, la différence des deux épaisseurs correspondant à une profondeur (e) de gravure d'une partie de la périphérie interne de ladite couronne, la zone active comprenant une membrane suspendue (44) dont des flancs (48) sont solidaires de la région d'isolement.

10. Dispositif selon la revendication 9, comprenant des conducteurs de grilles isolées supérieure (94) et inférieure (96), disposés respectivement sur et sous la membrane, la membrane comprenant des régions de source et de drain.
